# EUROPEAN PATENT SPECIFICATION

(11) **EP 3 973 032 B1**
(45) Date of publication and mention of the grant of the patent: **27.09.2023**
(21) Application number: 20725029.1
(22) Date of filing: 22.04.2020
(51) Int. Cl.: C09K 5/14, H01M 10/653

(54) **THERMAL INTERFACE MATERIALS**
THERMISCHES ZWISCHENMATERIAL
MATÉRIAUX D'INTERFACE THERMIQUE

(30) Priority: 21.05.2019 US 201962850791 P
(43) Date of publication of application: 30.03.2022
(73) Proprietor: DDP Specialty Electronic Materials US, LLC, Wilmington, DE 19805 (US)
(72) Inventor: GRUNDER, Sergio, 8807 Freienbach (CH); HILLESHEIM, Nina, 8807 Freienbach (CH); LUTZ, Andreas, 8807 Freienbach (CH); ARDIZZONE, Filippo, 8807 Freienbach (CH)
(74) Representative: Dannenberger, Oliver Andre
(86) International application number: PCT/US2020/029248
(87) International publication number: WO 2020/236384

(56) References cited:
- US-A1- 2007 097 651
- US-A1- 2017 321 100
- US-A1- 2018 030 328
- US-A1- 2018 282 604

## Description

### FIELD

The teachings herein are directed to thermal interface materials having generally high thermal conductivity, components and articles including the thermal interface material, and related methods. The thermal interface materials include an oligomeric or polymeric matrix phase and one or more thermally conductive fillers dispersed in the matrix phase.

### BACKGROUND

The automotive industry has seen a trend to reduce the weight of the vehicles in the past decade. This lightweight trend has been mainly driven by regulations to reduce the CO₂ emission of the vehicle fleet. In recent years lightweight construction strategies have been further fueled by the increasing number of electrically driven vehicles. The combination of a growing automotive market and a growing market share of electrically powered vehicles leads to a strong growth in the number of electrically driven vehicles. To provide long driving ranges batteries with a high energy density are needed. Several battery strategies are currently followed with differing detailed concepts, but what all long-range durable battery concepts have in common is that a thermal management is needed. In particular, to thermally connect battery cells or modules to a cooling unit, thermal interface materials are needed.

Various composition include conductive fillers are described in PCT Patent Application numbers WO 2001/041213 A1: WO 2014/047932 A1, WO 2015/148318 A1; WO 2016/145651 A1; WO 2017/091974 A1; WO 2018/34721; and WO 2006/016936 A1; European Patent Application EP 1438829 A1; Japan Patent Application JP 2010/0138357 A; and US Patent Application US 2009/0250655 A1. In these prior attempts, the compositions suffered on one or more of the needs for an affordable thermal interface material, such as the thermal conductivity of the composition is insufficient, the composition is difficult to produce, the composition does not properly fill gaps so that the contact is insufficient; the composition requires expensive material; or the composition requires abrasive filler that can damage processing equipment. Thermal interface materials are also described in US 2018/030328 A1, US 2017/321100 A1 and US 2007/097651 A1. US 2018/282604 A1 relates to a thermally conductive polymer resin composition.

There continues to exist a need for a thermal interface material having both high thermal conductivity and low viscosity. There is also a continuing need for thermal interface materials having filler materials that are non-abrasive. There is also a continuing need for thermal interface materials that are more economical with respect to raw material costs and/or manufacturing / processing costs.

### SUMMARY

One or more of the above needs may be achieved using a thermal interface material according to the teachings herein. Accordingly, the present invention relates to a composition as defined in claims 1 to 12, an article as defined in claims 13 and 14, and a method as defined in claim 15.

One aspect of the teachings herein is directed at a composition comprising: a continuous matrix phase including an oligomer or polymer which includes alkoxide groups, and a dispersed filler phase including conductive filler dispersed in the matrix phase, wherein the filler includes aluminum hydroxide; wherein the filler has a broad particle size distribution characterized by a ratio of D₉₀ / D₅₀ of about 3 or more; and wherein the filler is covered and/or reacted with a surface modifier.

Another aspect according to the teachings herein is directed at a composition comprising: a continuous matrix phase including a polymer or polymerizable compound which includes alkoxide groups, and about 86 weight percent or more, based on the total weight of the composition, of a dispersed filler phase including conductive filler dispersed in the matrix phase, wherein the filler includes aluminum hydroxide; wherein the conductive filler has a broad particle size distribution characterized by a ratio of D₉₀ / D₅₀ of about 3 or more.

Any of the aspects according to the teachings herein may be further characterized by one or any combination of the following features: the composition is a thermal interface material having a thermal conductivity of about 2.0 W/mK or more (preferably about 2.5 W/mK or more, and more preferably about 3.0 W/mK or more); the one or more fillers is a conductive filler (i.e., a thermally conductive filler) having a thermal conductivity of about 3 W/mK to about 80 W/mK); the conductive filler has a thermal conductivity of about 60 W/mK or less (e.g., about 40 W/mK or less, or about 20 W/mK or less); the conductive filler has a Mohs hardness of about 6 or less, preferably about 5 or less, and more preferably about 4 or less; the oligomer or polymer has a weight average molecular weight of about 15,000 g/mol or less, or about 10,000 g/mol or less; the surface modifier includes an alkyl group with about 6 or more (preferably about 8 or more, or about 10 or more, or about 12 or more) carbon atoms and a functional group on one end that covalently bonds with the filler; the surface modifier is present in an amount from about 0.05 weight percent or more (preferably about 0.2 weight percent or more, and more preferably about 0.5 weight percent or more) based on the total weight of the composition; the surface modifier is present in an amount of about 10 weight percent or less, preferably about 8 weight percent or less, more preferably about 6 weight percent or less, and most preferably about 4 weight percent or less; the amount of the filler is about 86 weight percent or more, based on the total weight of the composition; the amount of the filler is about 95 weight percent or less, based on the total weight of the composition; the one or more functional groups of the surface modifier includes an alkoxysilane group; the composition has a viscosity of about 700 N or less (as determined by press-in force at 0.5 mm; or the total amount of the oligomer or polymer of the matrix phase, the surface modifier (if present), and the filler is about 95 weight percent or more (preferably about 97 weight percent or more, or about 99 weight percent or more, or about 100 weight percent) based on the total weight of the composition.

Another aspect is directed at an article including a layer of a composition according to the teachings herein. The article may include a first component that generates heat and or a second component for removing heat. Preferably the article includes both the first component and the second component and the layer is interposed between the first and second components and the layer provides a path for the flow of heat form the first component to the second component. Preferably the first component includes a battery cell.

Another aspect is direct at a method for cooling a device comprising the steps of: generating heat in a first component; transferring the heat to a second component by flowing the heat through a thermal interface component; wherein the thermal interface component is formed of a composition according to the teachings herein.

### BRIEF DESCRIPTION OF DRAWINGS

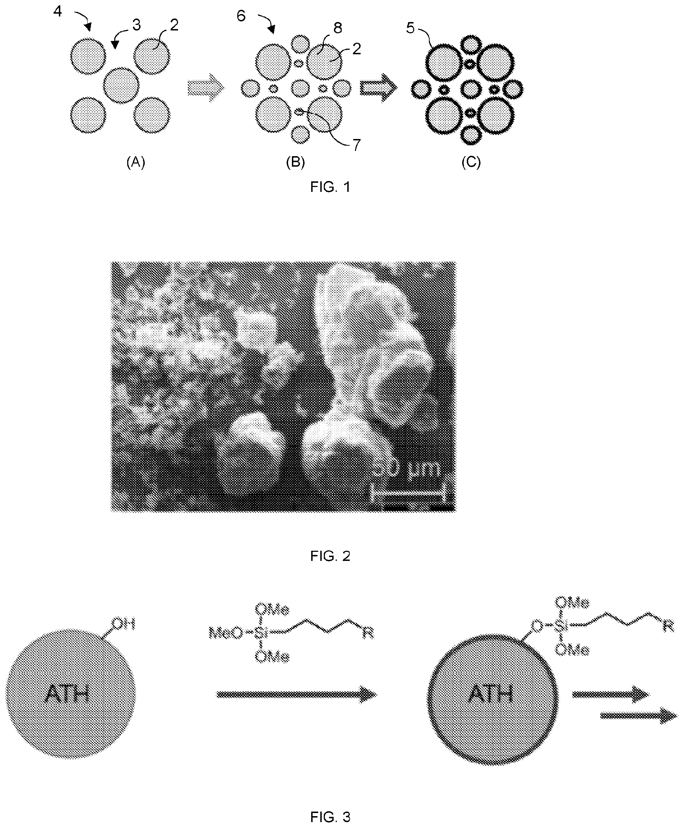

FIG. 1 is a drawing illustrating features of a composition having a filler with a generally narrow particle size distribution (A) (not according to the invention), a composition having a filler with a generally broad particle size distribution (B) (not according to the invention), and a composition having a filler with a generally broad particle size distribution that has been surface modified (C).
FIG. 3 is a drawing illustrating features of a reaction between a surface modifier and a conductive filer. For example, a surface modifier may change the hydrophobicity of the surface.

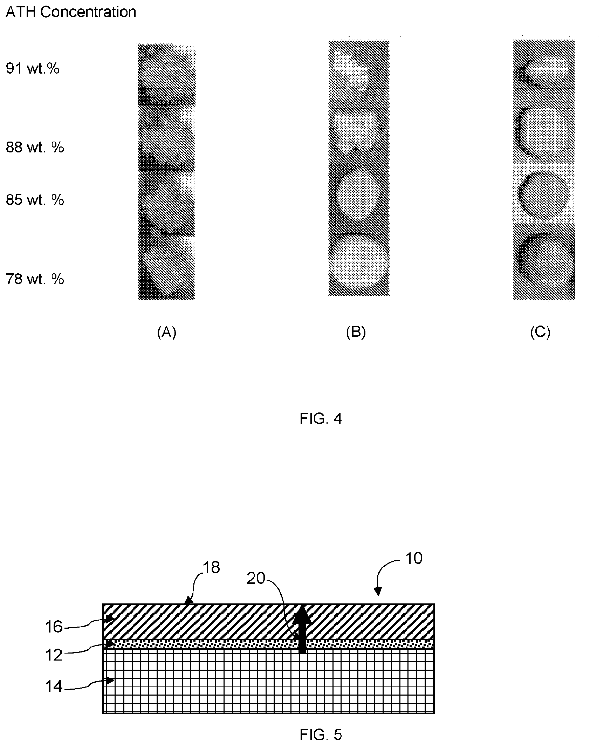

FIG. 4 is a drawing showing illustrative compositions having different amounts of filler where the filler (A) has a narrow particle size distribution (not according to the invention); (B) has a broad particle size distribution (not according to the invention), and (C) has a broad particle size distribution and a surface modifier to reduce or minimize the bonding between the matrix phase material and the filler.
FIG. 2 is an optical micrograph of an illustrative conductive filler having a broad particle size distribution.
FIG. 5 is a drawing showing illustrative features of a device including a thermal interface material.
FIG. 6 is an illustrative drawing of a battery including a thermal interface material.

### DETAILED DESCRIPTION

Unless otherwise specified, the term "consisting essentially of" includes an amount of about 90 weight percent or more, about 95 weight percent or more, about 98 weight percent or more, or about 99 weight percent or more.

Unless otherwise specified the term "conductive" and "conductivity" refers to "thermally conductive" and "thermal conductivity".

The thermal interface material includes two or more phases and preferably includes two phases. A first phase of the thermal interface material is a matrix phase. The matrix phase preferably is a continuous phase. However, the matrix phase may be a co-continuous phase and/or include one or more sub-phases. Preferably the matrix phase includes, consists essentially of, or consists entirely of one or more polymers, oligomers, or polymerizable compounds. The matrix phase preferably includes, consists essentially of, or consists entirely of one or more materials that are liquid at room temperature or require minimal heating to become a liquid. The second phase is a discrete phase that is dispersed in the matrix phase. It will be appreciated that the discrete phase may be coated with one or more additional phases that provides an interface between the discrete phase and the matrix phase. Typically, the matrix phase includes materials having generally low thermal conductivity (e.g., about 1 W/mK or less, or about 0.2 W/mK or less) so that thermal conductivity of the composition relies primarily on the discrete phase. The discrete phase includes one or more filler materials that are solid at room temperature. Because the filler phase is required to provide much of the thermal transport, it is necessary to include high concentrations of the filler to overcome the fact that the filler particles are generally dispersed in the matrix phase.

Molecular weight (i.e., weight average molecular weight)

When mixed with the filler, the matrix phase material preferably has a low molecular weight so that it can easily flow and combine with large amounts of filler (such as described herein). Preferably, the matrix phase material has a sufficiently low molecular weight that it is a liquid at room temperature. When mixed with the filler, the matrix phase material may have a molecular weight of about 40,000 g/ mole or less, about 15,000 g/mole or less, about 10,000 g/mole or less, about 8,000 g/mole or less, about 6,000 g/mole or less, or about 4,000 g/mole or less. The matrix phase material may have a molecular weight of about 200 g/mole or more, about 400 g/mole or more, about 600 g/mole or more, about 800 g/mole or more, or about 1000 g/mole or more.

The matrix phase may be characterized by a melting temperature above or below room temperature, or may be an amorphous material that does not crystallize. The matrix phase may be characterized by one or more glass transition temperatures. Unless otherwise specified, melting temperatures and glass transition temperatures are measured using differential scanning calorimetry at a heating rate of 10 °C / min according to ASTM D3418-15.

The matrix phase preferably is a liquid at a temperature of about 75 °C and does not exhibit any glass transition temperatures above 75 °C. More preferably, the matrix phase is a liquid at a temperature of about 40 °C and does not exhibit any glass transition temperatures above 40 °C. Most preferably, the matrix phase is a liquid at a temperature of about 20 °C (or even at about 5 °C) and does not exhibit any glass transition temperatures above 20 °C (or even above 5 °C). As such, the neat matrix phase material may be pumpable at a temperature of about 75 °C, about 40 °C, about 20 °C, or about 5 °C.

The matrix phase material may have a molecular weight that increases, such as by polymerization, cross-linking, or curing. If the molecular weight of the matrix material is increased, such reaction preferably is after the mixing of the matrix material with the filler. For example, the molecular weight may increase after the composition is applied alone or with one or more other components on a surface of a device for which thermal management is required. The one or more other components may include a compound that mixes with and/or reacts with the matrix phase material. When the molecular weight of the matrix phase material is increased, it preferably is sufficiently increased so that the matrix phase does not flow. For example, the matrix phase may become cross-linked so that is incapable of flowing, and/or a glass transition temperature of the matrix phase material may increase to about 30 °C or more, about 50 °C or more, about 70 °C or more, or about 90 °C or more.

The matrix phase material may be an organic material having a backbone including carbon atoms, or may be silicon-based material including a backbone having silicon atoms (e.g., -Si-O- groups). Organic materials include oligomers and polymers that include one or more monomers selected from the group consisting of an olefin, an alkoxide, a carbonate, an acrylate, an acrylonitrile, a diene, a bisphenol, a diacid, a diamine, a diol, and an isocyanate. The matrix phase material includes, consists essentially of, or consists entirely of an alkoxide oligomer or polymer. Preferred alkoxides include ethylene oxide, propylene oxide, and butylene oxide.

The matrix phase material may include reactive or may be generally free of reactive groups. By way of example, an alkoxide oligomer or polymer molecule may be end capped so that it is generally free of reactive OH groups. Alternatively, an alkoxide oligomer or polymer molecule may be a linear molecule with an OH group on one or both ends. It is also possible that the alkoxide oligomer have a branched structure with 3 or more arms. Such a structure may have no OH groups, a single OH groups, two OH groups, three OH groups, or four or more OH groups. For example, the alkoxide oligomer may be initiated with glycerin so that it has three arms. Each of the arms may have an OH group, or one more of the arms may be end capped. The end-capping may form an ester group with a terminal alkyl group, which preferably is a methyl, ethyl, propyl, or butyl group.

### Fillers

The compositions according to the teachings herein include one or more fillers for increasing the thermal conductivity of the composition. Although the filler may include an ultra high conductivity filler (e.g., a filler having a thermal conductivity of about 100 W/mK), such fillers are typically abrasive and/or expensive. Preferably, the one or more fillers includes, consists essentially of, or consists entirely of one or more conductive fillers having thermal conductivity of about 80 W/mK or less, about 50 W/mK or less, about 30 W/mK or less, about 20 W/mK or less, or about 15 W/mK or less. The conductive filler preferably has a thermal conductivity of about 3 W/mK or more, about 4 W/mK or more, about 5 W/mK or more, or about 6 W/mK or more. The conductive filler may be characterized by a thermal conductivity of about 10 +/- 10%, about 10 +/- 20%, or about 10 +/-30%. Preferably, the amount of ultra high conductivity filler in the composition is about 15 weight percent or less, more preferably about 4 weight percent or less, even more preferably about 1 weight percent or less, and most preferably about 0.3 weight percent or less, based on the total weigh of the one or more fillers. The amount of ultra high conductivity filler in the composition may be about 0.0 percent or more, based on the total weight of the one or more fillers. The amount of the conductive filler (i.e., excluding ultra high conductivity filler) may be about 80 weight percent or more, about 85 weight percent or more, about 90 weight percent or more, about 93 weight percent or more, about 96 weight percent or more, about 98 weight percent or more, about 99 weight percent or more, or about 99.7 weight percent or more, based on the total weight of the one or more fillers. The amount of the conductive filler may be about 100 weight percent or less, based on the total weight of the one or more fillers.

The ultra high conductivity filler, if present, may be any filler have a thermal conductivity of about 100 W/mK. Examples of ultra high conductivity fillers include boronnitrides and aluminum powder.

The conductive filler may be any filler having a thermal conductivity such as described herein and including aluminum hydroxide. For example, the conductive filler may have a thermal conductivity of about 3 W/mK to about 80 W/mK. The conductive filler preferably is non-abrasive (e.g., is less abrasive than boronnitride, less abrasive than aluminum powder, or both). An example of a non-abrasive conductive filler is aluminum hydroxide (i.e., ATH) powder. Aluminum hydroxide powder has a thermal conductivity between 3 and 80 W/mK (typically about 10 W/mK).

The conductive filler typically includes one or more metal or metalloid atoms and one or more atoms that is a nonmetal. Metalloid atoms include boron, silicon, germanium, arsenic, antimony, and tellurium. Preferred metal atoms include alkali metals, alkaline earth metals, transition metals, and post-transition metals. The amount of nonmetal atoms in the conductive filler should be sufficiently high so that the conductive filler is not hard and abrasive. Examples of metal or metalloid containing fillers that are hard and abrasive include SiC, TiC, and BN. These hard and abrasive fillers include 50 atomic percent of the metal or metalloid. Preferably the concentration of the nonmetal atoms in the conductive filler is more than about 50 atomic percent nonmetal atoms, more preferably about 65 percent or more, even more preferably about 75 percent or more, and most preferably about 80 percent or more, based on the total number of atoms in the conductive filler. The concentration of the nonmetal atoms may be about 95 atomic percent or less, about 93 atomic percent or less, about 90 atomic percent or less or about 88 atomic percent or less. The conductive filler preferably has a sufficient concentration of metal atoms so that the thermal conductivity is about 3 W/mK. The combined concentration of any metal and metalloid in the conductive filler preferably is about 5 atomic percent or more. The combined concentration of any metal and metalloid in the conductive filler may be less than 50 atomic percent, about 35 atomic percent or less, about 25 atomic percent or less, or about 20 atomic percent or less.

Preferred compositions include a sufficient amount of the conductive filler so that the thermal conductivity of the composition is about 1.5 W/mK or more, preferably about 2.0 W/mK or more, more preferably about 2.5 W/mK or more, and most preferably about 3.0 W/mK or more. The thermal conductivity of the composition is typically about 10 W/mK or less, about 7 W/mK or less, or about 5 W/mK or less. If the amount of the conductive filler is too low, the composition will not be able to conduct heat sufficiently for managing the temperature of a device. In order to achieve such high thermal conductivity of the composition, the composition typically has high concentrations of the conductive filler. Preferably, the amount of the conductive filler in the composition is about 60 weight percent or more, more preferably about 70 weight percent or more, even more preferably about 75 weight percent or more, even more preferably about 80 weight percent or more, even more preferably about 85 weight percent or more, and most preferably about 88 weight percent or more, based on the total weight of the composition. The amount of the conductive filler in the composition should be sufficiently low so that the conductive filler can be dispersed in the matrix. Typically, the amount of conductive filler is about 95 weight percent or less, more preferably about 92 weight percent or less, based on the total weight of the composition.

The conductive filler preferably has a sufficiently low Mohs hardness so that it is generally non-abrasive. Preferably, the conductive filler has a Mohs hardness of about 7.0 or less, preferably about 5.0 or less, and more preferably about 4.0 or less. The conductive filler may have a Mohs hardness of about 0.5 or more, about 1.5 or more, or about 2.0 or more.

The conductive filler typically includes M-X bonds, where M is a metal and X is a nonmetal. Preferably the ratio of the M-X bonds to the M-M bonds (metal-metal bonds) in the filler may be about 2.0 or more, about 3.0 or more, or about 4.0 or more. It will be appreciated, that the conductive filler may be free of M-M bonds. An example of a conductive filler that is generally free of M-M bonds is aluminum hydroxide.

### Particle Size Distribution

In order to achieve a combination of high thermal conductivity of the composition and ability to mix and process the composition, the conductive filler preferably has a broad particle size distribution.

The broad particle size distribution may allow the particles to more efficiently pack together. The particle size distribution of the conductive filler may be measured using laser diffraction. The particle size distribution may be characterized by D₁₀, D₅₀, and D₉₀, corresponding to the 10^{th} percentile, 50^{th} percentile (median), and 90^{th} percentile of the particle sizes. Filler having a broad particle size distribution may be characterized by one or more of the following: a generally high ratio of D₉₀/D₅₀, a generally high ratio of D₉₀/D₁₀, or a generally high ratio of D₅₀/D₁₀, or any combination thereof. The ratio of D₉₀/D₅₀ is about 3 or more, about 4 or more, about 5 or more, about 6 or more or about 8 or more. The ratio of D₉₀/D₅₀ may be about 100 or less or about 40 or less. Preferably the ratio of D₉₀/D₁₀ is about 20 or more, about 40 or more, about 60 or more, or about 80 or more. The ratio of D₉₀/D₁₀ may be about 1000 or less or about 400 or less. The ratio of D₉₀/D₅₀ may be about 100 or less or about 40 or less. Preferably the ratio of D₅₀/D₁₀ is about 8 or more, about 10 or more, or about 12 or more. The ratio of D₅₀/D₁₀ may be about 100 or less or about 40 or less. The large particles in the conductive filler (as characterized by the D₉₀ value) should be sufficiently high so that sites are created for packing one or more smaller particles. Preferably D₉₀ is about 10 µm or more, more preferably about 20 µm or more, even more preferably about 40 µm or more, and most preferably about 60 µm or more. If D₉₀ is too large, it may be difficult to process the composition. Preferably, D₉₀ is about 2000 µm or less, more preferably about 1000 µm or less and most preferably about 500 µm or less. The small particles (as characterized by the D₁₀ value) in the conductive filler should be sufficiently small so that they can fit in sites between large particles. Preferably, D₁₀ is about 4 µm or less, about 2 µm or less, or about 1 µm or less. Typically, it is difficult and costly to make very small particles. As such, it is preferable that D₁₀ is about 0.1 µm or more, or about 0.25 µm or more, although smaller particles may be employed. The conductive filler may have a first portion having an average particle size of about 10 µm or less, and a second portion having an average particle size of about 50 µm or more (preferably, the first and second portions are each present in an amount of about 25 weight percent or more, about 30 weight percent or more, or about 35 weight percent or more of the conductive filler).

FIG. 1 illustrates the effect of having a broad particle size distribution 6 (B) on the ability to pack small particles 7 between larger particles 8 as compared to a filler having a narrow particle size distribution 4 (A). With the increase in particle concentration using a broad particle size distribution, particles 2 are closer and there may be bridging between two particles by the matrix phase material 3. Adhesion of the matrix phase to the particle surface and/or bridging may reduce the ability to flow or process the composition. In order to improve processability, the particles preferably have surface modifier. For example (C) has a broad particle size distribution 6 and a coating 5 (e.g., of a surface modifier) to reduce or minimize the bonding between the matrix phase material and the filler.

FIG. 2 is an optical micrograph of an example of a conductive filler, aluminum hydroxide (i.e., Al(OH)₃) having a broad particle size distribution.

### Filler Surface Modifier

Although in many filled polymer systems, it is desirable to have good compatibility and/or bonding between the matrix phase and the filler phase, Applicant has determined that for these highly filled compositions, such compatibility and/or bonding may create bridges between neighboring filler particles that prevent the flow of the composition. It is preferred that the matrix phase material does not bond with a surface of the filler. For example, the covalent bonding, ionic bonding, and hydrogen bonding may be reduced, minimized or even completely avoided. This can be achieved by selection of the matrix phase material and conductive filler material. Alternatively, the filler material may be treated with one or more surface modifiers for reducing, minimizing or eliminating bonding with the matrix phase material.

The surface modifier may partially or completely cover the surface of the conductive filler particle. The surface modifier may have one or more functional groups that reacts with the conductive filler particle. As such, the surface modifier may be covalently bonded to the conductive filler. By way of example, the conductive filler may include M-OH groups, where Mis a metal atom, and the surface modifier may include a functional group that reacts with the M-OH group to form a direct or indirect bond between the surface modifier and M.

The surface of the conductive filler may be hydrophobized with the surface modifier. For example, the surface modifier may include an alkyl component and one or more functional group at or near one end of the alkyl component. The alkyl component preferably includes about 6 or more carbon atoms, more preferably about 8 or more carbon atoms, even more preferably about 10 or more carbon atoms, and most preferably about 12 or more carbon atoms. The one or more functional groups may be selected to react with surface of the conductive filler. For example, the one or more function groups may include one or more alkoxysilanes. Such a functional group may be particularly useful for bonding the surface modify to a conductive filler including M-OH groups, such as in aluminum hydroxide. An example of a reaction between a conductive filler and a surface modifier is shown in FIG. 3.

It will be appreciated that the surface modifier may be added to the filler before or after mixing the conductive filler with the matrix phase material. For example, the conductive filler may be coated and/or reacted with the surface modifier prior to mixing the conductive filler and the matrix phase material. As another example, the surface modifier may be mixed with the matrix phase material to form a premix which is then combined with the conductive filler. As another example, the conductive filler and the matrix phase material may be mixed and then the surface modifier may be added to the mixture.

As illustrated in FIG. 4(A), when a conductive filler having a narrow particle size distribution is employed, the resulting composition may have a rough surface even when the filler loading is low, (e.g., only about 60 weight percent). As illustrated in FIG. 4(B), the ability to increase the filler loading is improved by using a filler having a broad particle size distribution. As illustrated in FIG. 4(C), the ability to increase the filler loading is further improved by using a filler having a broad particle size distribution and also adding a surface modifier that reduces, minimizes or eliminates bonding between the matrix phase material and the filler particles.

The total amount of the oligomer or polymer of the matrix phase, the surface modifier (if present), and the one or more fillers may be about 95 weight percent or more, about 97 weight percent or more, about 99 weight percent or more, or about 100 weight percent, based on the total weight of the composition.

### Applications

The thermal interface material according to the teachings herein may be used in any device or system requiring polymeric or oligomeric material having good thermal conductivity. FIG. 5 is a drawing of illustrating features of a device 10 including a thermal interface material 12. The device may require heat flow 20 from a first component 14 of the device, to a second component 16 of the device 10. As illustrated in FIG. 5, the heat flow may go through the thermal interface material 12. The second component 16 of the device may have a surface 20 (internal or external) that allows for removal of heat from second component.

The thermal interface material may be used as a gap fill material. The thermal interface material may be used as a sealing material. In some applications, it may be necessary to apply thin layers of the thermal interface material (e.g., about 2 mm or less, about 1 mm or less, about 0.5 mm or less or about 0.3 mm or less). As such, the thermal interface material preferably has a low viscosity and/or has a good mixing behavior (e.g., having a smooth appearance that does not crumble after mixing) so that thin regions or layers may be prepared.

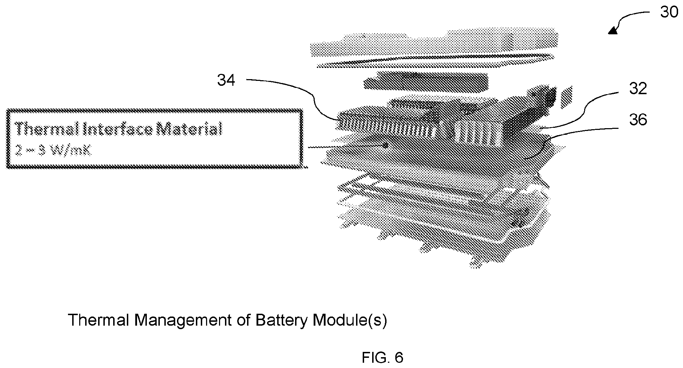

Article including one or more battery cells, a cell cover having a surface for contacting with a cooling unit or with a circulating cooling fluid, and a thermal interface material interposed between the battery cell and the cell cover. The thermal interface material provides a path for conducting thermal energy from the battery cell to the cell cover for managing the temperature of the battery cell. The battery cells may be provided as one or more modules. Without the thermal interface material, there may be a gap (at least in some regions) between the battery module and a conductive plate (e.g., of a housing). FIG. 6 is a drawing illustrating features that may be employed in thermal management of one or more battery modules. The battery / thermal management system 30 includes a thermal interface material 32 for filling a gap between one or more battery modules 34 and a metal surface 36. The thermal interface material may be applied by placing on a surface of the battery modules or by placing on the metal surface. The metal surface may be a cooling plate or other component arranged for drawing heat out of the system.

### Test methods

Particle size distribution.

Unless otherwise stated, the particle size distribution of the filler is measured by laser diffraction.

### Thermal conductivity

Thermal conductivity is measured using a thermal interface material tester from ZFW Stuttgart. The measurement is performed in Spaltplus mode at a thickness of between 1.8 - 1.2 mm. The absolute thermal conductivity λ (W/mK) is reported. Thermal conductivity may be measured according to ASTM 5470.

### Press-in Force

The press-in force is measured with a tensiometer (Zwick). The composition (e.g.., the gap filler material) is placed on a metal surface. An aluminum piston with a diameter of about 40 mm diameter is placed on top and the material is compressed to an initial position of 5 mm. The material is then compressed from 5 mm to 0.3 mm at a velocity of about 1 mm/s velocity and force deflection curve is recorded. The force (N) at 0.5 mm thickness is then reported in the data table and considered as the press-in force. A material having a low viscosity has a press-in force of 700 N or less. A high viscosity material has a press-in force greater than 700 N, or about 800 N or more. A material having a low viscosity preferably has a press-in force of about 600 N or less, even more preferably about 500 N or less, and most preferably about 400 N or less.

### Mixing Ability

The ability to mix the composition was determined by the ability to create a single mass of material having a smooth surface. Such materials having "good" mixing. When the surface is rough and/or the material crumbles upon removing from the mixer, the mixing is poor.

### Materials

POLYOL-1 is a glycerine initiated propylene oxide polyether triol with an equivalent molecular weight of about 1800 g/mol and an OH number of about 35 mg KOH/g. The average molecular weight is about 4800 g/mole. POLYOL-1 is a liquid at room temperature and is free of any glass transition temperatures of 5 °C or more. This oligomer is partially capped with ethylene oxide (approximately 11%).

ATH-1 is an aluminum hydroxide having a broad particle size distribution. It is believed that ATH- has a bimodal particle size distribution. The amount of Al(OH)₃ is about 99.7 weight percent. Features of the particle size distribution are listed in Table 1. This filler is characterized by a sieve residue of about 35%, using a 45µm sieve. The broad and/or bimodal particle size distribution of ATH-1 is illustrated in FIG. 2. The average size of the smaller particles is less than about 10 µm; and the average size of the larger particles is greater than about 50 µm.

ATH-2 is an aluminum hydroxide having a generally narrow particle size distribution. It is believed that ATH-2 has a generally monomodal particle size distribution. The amount of AL(OH)₃ is about 99.4 weight percent. Features of the particle size distribution are listed in Table 1. ATH-2 is characterized by a sieve residue of about 0.2% using a 45 µm sieve.

DYNASYLAN^{®} 9116 is a silane containing compound commercially available from EVONIK. This silane includes or consists essentially of hexadecyltrimethoxysilane.

| TABLE 1. PARTICLE SIZE DISTRIBUTION | | |
|---|---|---|
| ATH GRADE | ATH-1 | ATH-2 |
| Distribution Type | Broad or Bimodal | Narrow or Monomodal |
| Sieve residue (>45µm), % | 35 | 0.1 |
| D₁₀, µm | 0.5 | 1.1 |
| D₅₀, µm | 8 | 8 |
| D₉₀, µm | 80 | 19 |
| D₉₀/D₅₀ | 10 | 2.4 |
| D₉₀/D₁₀ | 160 | 17.3 |
| Al(OH)₃ concentration, wt. % | 99.7 | 99.4% |

### Examples

Filled compounds are prepared in a planetary mixer or on a dual asymmetric centrifuge. Initially, the liquid materials (i.e., the surface modifier and the matrix phase material are mixed together under vacuum. Then the filler is added and the composition is mixed for 30 minutes.

Examples 1-8 (not according to the invention) are prepared using a filler having a generally narrow particle size distribution, ATH-2. In Examples 1-4, the liquid material is VORANOL^{™} CP 4610 and the composition consists only of the filler and the VORANOL^{™} CP 4610. The concentration of the filler and matrix phase for these compositions are shown in TABLE 2. In Examples, 5-8, the compositions include ATH-2, VORANOL^{™} CP4610, and DYNASYLAN^{®} 9116 in the amounts listed in Table 3.

| TABLE 2. Compositions including alkylene oxide based oligomer and ATH with narrow particle size distribution, without surface modification. | | | | |
|---|---|---|---|---|
| | Example 1 | Example 2 | Example 3 | Example 4 |
| Composition | | | | |
| ATH-2, weight percent | 78.09 | 84.75 | 87.71 | 90.85 |
| VORANOL^{™} CP 4610, weight percent | 21.91 | 15.25 | 12.29 | 9.15 |
| Total | 100.00 | 100.00 | 100.00 | 100.00 |
| Mixing | Good | Poor | Poor | Poor |
| Press-in Force at 0.5 mm, N | 1348 | Not measured | Not measured | Not measured |
| Thermal conductivity, W/mK | 1.12 | Not measured | Not measured | Not measured |

| TABLE 3. Compositions including alkylene oxide based oligomer and ATH with narrow particle size distribution, with surface modification. | | | | |
|---|---|---|---|---|
| | Example 5 | Example 6 | Example 7 | Example 8 |
| Composition | | | | |
| ATH-2, weight percent | 78.09 | 84.75 | 87.71 | 90.85 |
| VORANOL^{™} CP 4610, weight percent | 19.91 | 13.25 | 10.29 | 7.15 |
| Hexadecyltrimethoxysilane, weight % | 2.0 | 2.0 | 2.0 | 2.0 |
| Total | 100.00 | 100.00 | 100.00 | 100.00 |
| Mixing | Good | Good | Poor | Poor |
| Press-in Force at 0.5 mm, N | 469 | 1998 | 5285 | Not measured |
| Thermal conductivity, W/mK | 1.13 | 1.56 | 1.68 | Not measured |

Examples 9-16 are prepared using a filler having a generally broad particle size distribution, ATH-1. In Examples 9-12 (not according to the invention), the liquid material is VORANOL^{™} CP 4610 and the composition consists only of the filler and the VORANOL^{™} CP 4610. The concentrations of the materials in these compositions are shown in TABLE 4. In Examples, 13-18, the compositions include ATH-1, VORANOL^{™} CP4610, and DYNASYLAN^{®} 9116 in the amounts listed in Table 5.

| TABLE 4. Compositions including alkylene oxide based oligomer and ATH with broad particle size distribution, without surface modification. | | | | |
|---|---|---|---|---|
| | Example 9 | Example 10 | Example 11 | Example 12 |
| Composition | | | | |
| ATH-1, weight percent | 78.09 | 84.75 | 87.71 | 90.85 |
| VORANOL^{™} CP 4610, weight percent | 21.91 | 15.25 | 12.29 | 9.15 |
| Total | 100.00 | 100.00 | 100.00 | 100.00 |
| Mixing | Good | Good | Good | Poor |
| Press-in Force at 0.5 mm, N | 204 | 642 | 1342 | Not measured |
| Thermal conductivity, W/mK | 1.57 | 2.15 | 2.54 | Not measured |

| TABLE 5. Compositions including alkylene oxide based oligomer and ATH with broad particle size distribution, with surface modification. | | | | | | |
|---|---|---|---|---|---|---|
| | Example 13 | Example 14 | Example 15 | Example 16 | Example 16 | Example 16 |
| Composition | | | | | | |
| ATH-1, weight percent | 78.09 | 84.75 | 87.71 | 90.85 | 87.71 | 87.71 |
| VORANOL^{™} CP 4610, weight percent | 19.91 | 13.25 | 10.29 | 7.15 | 11.29 | 9.29 |
| Hexadecyltrimethoxysilane, weight % | 2.0 | 2.0 | 2.0 | 2.0 | 1.0 | 3.0 |
| Total | 100.00 | 100.00 | 100.00 | 100.00 | 100.00 | 100.00 |
| Mixing | Good | Good | Good | Good | Good | Good |
| Press-in Force at 0.5 mm, N | 124 | 303 | 485 | 1258 | 772 | 384 |
| Thermal conductivity, W/mK | 1.10 | 2.20 | 2.69 | 3.28 | 2.75 | Not measured |

As seen in Table 4, the use of the broad particle size distribution filler improved the ability to incorporate the filler into the composition. Good mixing (with smooth surface of composition) was obtained for the compositions with 78.1% and 84.7% filler. However, at higher levels of filler, the mixing was poor with rough surface. Also, the viscosity as determined by the press-in force at 0.5 mm was high.

As seen in Table 5, the combination of broad particle size distribution filler along with the silane surface modifier allowed for the incorporation of higher amounts of filler and for reducing the viscosity. Even at 90.85 weight percent filler loading (Example 16), the mixing was good, with a smooth surface and the viscosity was low as measured by the press-in force at 0.5 mm.

Press-in Force: The press-in force is measured with a tensiometer (Zwick). The gap filler material is placed on a metal surface. An aluminum piston with 40 mm diameter is placed on top and the material is compressed to 5 mm (initial position). The material is then compressed to 0.3 mm with 1 mm/s velocity and force deflection curve is recorded. The force (N) at 0.5 mm thickness is then reported in the data table and considered as the press-in force.

## Claims

1. A composition comprising:
i. a continuous matrix phase including an oligomer or polymer which includes alkoxide groups;
ii. a dispersed filler phase including conductive filler dispersed in the matrix phase, wherein the filler includes aluminum hydroxide;
wherein the filler has a broad particle size distribution **characterized by** a ratio of D₉₀ / D₅₀ of about 3 or more; and
wherein the filler is covered and/or reacted with a surface modifier.

2. The composition of claim 1, wherein the composition is a thermal interface material having a thermal conductivity of about 2.0 W/mK or more, preferably about 2.5 W/mK or more, and more preferably about 3.0 W/mK or more.

3. The composition of claim 1 or 2, wherein the filler is a thermally conductive filler having a thermal conductivity of about 3 W/mK to about 80 W/mK; and/or wherein the conductive filler has a thermal conductivity of about 60 W/mK or less, more preferably about 40 W/mK or less, and most preferably about 20 W/mK or less.

4. The composition of any of claims 1 through 3, wherein the conductive filler has a Mohs hardness of about 6 or less, preferably about 5 or less, and more preferably about 4 or less.

5. The composition of any of claims 1 through 4, wherein the oligomer or polymer has a weight average molecular weight of about 15,000 g/mol or less, preferably about 10,000 g/mol or less.

6. The composition of any of claims 1 through 5, wherein the surface modifier includes an alkyl group with about 6 or more, preferably about 8 or more, more preferably about 10 or more, and most preferably about 12 or more carbon atoms, and a functional group on one end that covalently bonds with the filler.

7. The composition of any of claims 1 through 6, wherein the surface modifier is present in an amount from about 0.05 weight percent or more, preferably about 0.2 weight percent or more, and more preferably about 0.5 weight percent or more, based on the total weight of the composition.

8. The composition of any of claims 1 through 7, wherein the surface modifier is present in an amount of about 10 weight percent or less, preferably about 8 weight percent or less, more preferably about 6 weight percent or less, and most preferably about 4 weight percent or less, based on the total weight of the composition.

9. The composition of any of claims 1 through 8, wherein the amount of the filler is about 86 weight percent or more, based on the total weight of the composition; and/or wherein the amount of the filler is about 95 weight percent or less, based on the total weight of the composition.

10. The composition of any of claims 1 through 9, wherein the one or more functional groups of the surface modifier includes an alkoxysilane group.

11. A composition comprising:
i. a continuous matrix phase including a polymer or polymerizable compound which includes alkoxide groups;
ii. about 86 weight percent or more, based on the total weight of the composition, of a dispersed filler phase including conductive filler dispersed in the matrix phase, wherein the filler includes aluminum hydroxide;
wherein the conductive filler has a broad particle size distribution **characterized by** a ratio of D₉₀ / D₅₀ of about 3 or more.

12. The composition of any of claims 1 through 11, wherein the composition is **characterized by** one or any combination of the following:
i) the composition has a viscosity of about 700 N or less (as determined by press-in force at 0.5 mm); and/or
ii) the composition has a thermal conductivity of about 3 W/mK or more.

13. An article comprising:
a first component that generates heat;
a second component for removing heat; and
a layer of the composition of any of claims 1 through 12 interposed between the first component and the second component;
wherein the layer provides a path for the flow of heat form the first component to the second component.

14. The article of claim 13, wherein the first component includes a battery cell.

15. A method for cooling a device comprising the steps of:
generating heat in a first component;
transferring the heat to a second component by flowing the heat through a thermal interface component; wherein the thermal interface component is formed of the composition of any of claims 1 through 12.

## Patentansprüche

1. Zusammensetzung umfassend:
i. eine kontinuierliche Matrixphase, die ein Oligomer oder Polymer umfasst, das Alkoxidgruppen umfasst,
ii. eine dispergierte Füllstoffphase, die einen leitfähigen Füllstoff umfasst, der in der Matrixphase dispergiert ist,
wobei der Füllstoff Aluminiumhydroxid umfasst,
wobei der Füllstoff eine breite Teilchengrößenverteilung aufweist, die durch ein Verhältnis von D₉₀/D₅₀ von etwa 3 oder mehr gekennzeichnet ist, und
wobei der Füllstoff mit einem Oberflächenmodifiziermittel bedeckt und/oder reagiert wird.

2. Zusammensetzung nach Anspruch 1, wobei die Zusammensetzung ein thermisches Zwischenmaterial ist, das eine Wärmeleitfähigkeit von etwa 2,0 W/mK oder mehr, bevorzugt etwa 2,5 W/mK oder mehr und noch bevorzugter etwa 3,0 W/mK oder mehr aufweist.

3. Zusammensetzung nach Anspruch 1 oder 2, wobei der Füllstoff ein wärmeleitfähiger Füllstoff ist, der eine Wärmeleitfähigkeit von etwa 3 W/mK bis etwa 80 W/mK aufweist, und/oder wobei der leitfähige Füllstoff eine Wärmeleitfähigkeit von etwa 60 W/mK oder weniger, noch bevorzugter etwa 40 W/mK oder weniger und am bevorzugtesten etwa 20 W/mK oder weniger aufweist.

4. Zusammensetzung nach einem der Ansprüche 1 bis 3, wobei der leitfähige Füllstoff eine Mohshärte von etwa 6 oder weniger, bevorzugt etwa 5 oder weniger und noch bevorzugter etwa 4 oder weniger aufweist.

5. Zusammensetzung nach einem der Ansprüche 1 bis 4, wobei das Oligomer oder Polymer ein gewichtsdurchschnittliches Molekulargewicht von etwa 15 000 g/Mol oder weniger, bevorzugt etwa 10 000 g/Mol oder weniger aufweist.

6. Zusammensetzung nach einem der Ansprüche 1 bis 5, wobei das Oberflächenmodifiziermittel eine Alkylgruppe mit etwa 6 oder mehr, bevorzugt etwa 8 oder mehr, noch bevorzugter etwa 10 oder mehr und am bevorzugtesten etwa 12 oder mehr Kohlenstoffatomen und eine funktionelle Gruppe an einem Ende umfasst, die sich an den Füllstoff kovalent bindet.

7. Zusammensetzung nach einem der Ansprüche 1 bis 6, wobei das Oberflächenmodifiziermittel in einer Menge von etwa 0,05 Gewichtsprozent oder mehr, bevorzugt etwa 0,2 Gewichtsprozent oder mehr und noch bevorzugter etwa 0,5 Gewichtsprozent oder mehr, auf das Gesamtgewicht der Zusammensetzung bezogen, vorliegt.

8. Zusammensetzung nach einem der Ansprüche 1 bis 7, wobei das Oberflächenmodifiziermittel in einer Menge von etwa 10 Gewichtsprozent oder weniger, bevorzugt etwa 8 Gewichtsprozent oder weniger, noch bevorzugter etwa 6 Gewichtsprozent oder weniger und am bevorzugtesten etwa 4 Gewichtsprozent oder weniger, auf das Gesamtgewicht der Zusammensetzung bezogen, vorliegt.

9. Zusammensetzung nach einem der Ansprüche 1 bis 8, wobei Menge des Füllstoffs etwa 86 Gewichtsprozent oder mehr, auf das Gesamtgewicht der Zusammensetzung bezogen, beträgt; und/oder wobei die Menge des Füllstoffs etwa 95 Gewichtsprozent oder weniger, auf das Gesamtgewicht der Zusammensetzung bezogen, beträgt

10. Zusammensetzung nach einem der Ansprüche 1 bis 9, wobei die eine oder mehreren funktionellen Gruppen des Oberflächenmodifiziermittels eine Alkoxysilangruppe umfassen.

11. Zusammensetzung umfassend:
i. eine kontinuierliche Matrixphase, die ein Polymer oder eine polymerisierbare Verbindung umfasst, die Alkoxidgruppen umfasst,
ii. etwa 86 Gewichtsprozent oder mehr, auf das Gesamtgewicht der Zusammensetzung bezogen, einer dispergierten Füllstoffphase, die einen leitfähigen Füllstoff umfasst, der in der Matrixphase dispergiert ist,
wobei der Füllstoff Aluminiumhydroxid umfasst,
wobei der leitfähige Füllstoff eine breite Teilchengrößenverteilung aufweist, die durch ein Verhältnis von D₉₀/D₅₀ von etwa 3 oder mehr gekennzeichnet ist.

12. Zusammensetzung nach einem der Ansprüche 1 bis 11, wobei die Zusammensetzung durch eine oder irgendeine Kombination Folgender gekennzeichnet ist:
i) die Zusammensetzung weist eine Viskosität von etwa 700 N oder weniger (wie durch Einpresskraft bei 0,5 mm bestimmt) auf; und/oder
ii) die Zusammensetzung weist eine Wärmeleitfähigkeit von etwa 3 W/mK oder mehr auf.

13. Artikel umfassend:
eine erste Komponente, die Wärme erzeugt;
eine zweite Komponente zum Entfernen von Wärme; und
eine Schicht der Zusammensetzung nach einem der Ansprüche 1 bis 12, die zwischen der ersten Komponente und der zweiten Komponente eingeschoben ist,
wobei die Schicht einen Weg für den Wärmefluss von der ersten Komponente zu der zweiten Komponente bereitstellt.

14. Artikel nach Anspruch 13, wobei die erste Komponente eine Batteriezelle umfasst.

15. Verfahren zum Kühlen einer Vorrichtung, umfassend die folgenden Schritte:
Erzeugen von Wärme in einer ersten Komponente,
Überführen der Wärme an eine zweite Komponente durch Fließenlassen der Wärme durch eine thermische Zwischenkomponente, wobei die thermische Zwischenkomponente aus der Zusammensetzung nach einem der Ansprüche 1 bis 12 gebildet ist.

## Revendications

1. Composition comprenant :
i. une phase de matrice continue comprenant un oligomère ou un polymère qui comprend des groupes alcoxydes ;
ii. une phase de charge dispersée comprenant une charge conductrice dispersée dans la phase de matrice,
dans laquelle la charge comprend de l'hydroxyde d'aluminium ;
dans laquelle la charge présente une distribution large de tailles de particule **caractérisée par** un ratio de D₉₀/D₅₀ d'environ 3 ou plus ; et
dans laquelle la charge est recouverte et/ou mise à réagir avec un agent de modification de surface.

2. Composition selon la revendication 1, dans laquelle la composition est un matériau d'interface thermique ayant une conductivité thermique d'environ 2,0 W/mK ou plus, préférablement d'environ 2,5 W/mK ou plus, et plus préférablement d'environ 3,0 W/mK ou plus.

3. Composition selon la revendication 1 ou 2, dans laquelle la charge est une charge thermiquement conductrice ayant une conductivité thermique d'environ 3 W/mK à environ 80 W/mK ; et/ou dans laquelle la charge conductrice présente une conductivité thermique d'environ 60 W/mK ou moins, plus préférablement d'environ 40 W/mK ou moins, et de manière préférée entre toutes d'environ 20 W/mK ou moins.

4. Composition selon l'une quelconque des revendications 1 à 3, dans laquelle la charge conductrice présente une dureté de Mohs d'environ 6 ou moins, préférablement d'environ 5 ou moins, et plus préférablement d'environ 4 ou moins.

5. Composition selon l'une quelconque des revendications 1 à 4, dans laquelle l'oligomère ou le polymère présente un poids moléculaire moyen en poids d'environ 15 000 g/mole ou moins, préférablement d'environ 10 000 g/mole ou moins.

6. Composition selon l'une quelconque des revendications 1 à 5, dans laquelle l'agent de modification de surface comprend un groupe alkyle d'environ 6 ou plus, préférablement d'environ 8 ou plus, plus préférablement d'environ 10 ou plus, et de manière préférée entre toutes d'environ 12 ou plus atomes de carbone, et un groupe fonctionnel sur une extrémité qui se lie de manière covalente à la charge.

7. Composition selon l'une quelconque des revendications 1 à 6, dans laquelle l'agent de modification de surface est présent en une quantité d'environ 0,05 pour cent en poids ou plus, préférablement d'environ 0,2 pour cent en poids ou plus, et plus préférablement d'environ 0,5 pour cent en poids ou plus, sur la base du poids total de la composition.

8. Composition selon l'une quelconque des revendications 1 à 7, dans laquelle l'agent de modification de surface est présent en une quantité d'environ 10 pour cent en poids ou moins, préférablement d'environ 8 pour cent en poids ou moins, plus préférablement d'environ 6 pour cent en poids ou moins, et de manière préférée entre toutes d'environ 4 pour cent en poids ou moins, sur la base du poids total de la composition.

9. Composition selon l'une quelconque des revendications 1 à 8, dans laquelle la quantité de la charge est d'environ 86 pour cent en poids ou plus, sur la base du poids total de la composition ; et/ou dans laquelle la quantité de la charge est d'environ 95 pour cent en poids ou moins, sur la base du poids total de la composition.

10. Composition selon l'une quelconque des revendications 1 à 9, dans laquelle les un ou plusieurs groupes fonctionnels de l'agent de modification de surface comprennent un groupe alcoxysilane.

11. Composition comprenant :
i. une phase de matrice continue comprenant un polymère ou un composé polymérisable qui comprend des groupes alcoxydes ;
ii. environ 86 pour cent en poids ou plus, sur la base du poids total de la composition, d'une phase de charge dispersée comprenant une charge conductrice dispersée dans la phase de matrice,
dans laquelle la charge comprend de l'hydroxyde d'aluminium ;
dans laquelle la charge conductrice présente une distribution large de tailles de particule **caractérisée par** un ratio de D₉₀/D₅₀ d'environ 3 ou plus.

12. Composition selon l'une quelconque des revendications 1 à 11, dans laquelle la composition est **caractérisée par** une ou une quelconque combinaison de ce qui suit :
i) la composition présente une viscosité d'environ 700 N ou moins (telle que déterminée par une force d'intégration à 0,5 mm) ; et/ou
ii) la composition présente une conductivité thermique d'environ 3 W/mK ou plus.

13. Article comprenant :
un premier composant qui génère de la chaleur ;
un deuxième composant de retrait de chaleur ; et
une couche de la composition selon l'une quelconque des revendications 1 à 12, interposée entre le premier composant et le deuxième composant ;
dans lequel la couche fournit un trajet pour l'écoulement de chaleur depuis le premier composant vers le deuxième composant.

14. Article selon la revendication 13, dans lequel le premier composant comprend une cellule de batterie.

15. Procédé de refroidissement d'un dispositif comprenant les étapes consistant à :
générer de la chaleur dans un premier composant ;
transférer la chaleur vers un deuxième composant en faisant s'écouler la chaleur à travers un composant d'interface thermique ; dans lequel le composant d'interface thermique est formé de la composition selon l'une quelconque des revendications 1 à 12.
